# EUROPEAN PATENT SPECIFICATION

(11) **EP 3 567 751 B1**
(45) Date of publication and mention of the grant of the patent: **30.11.2022**
(21) Application number: 19183544.6
(22) Date of filing: 28.06.2013
(51) Int. Cl.: H04B 7/185, G06Q 10/10

(54) **MODULAR MOBILE PLATFORM FOR USE WITH COMMERCIAL DEVICES**
MODULARE MOBILE PLATTFORM ZUR VERWENDUNG MIT KOMMERZIELLEN VORRICHTUNGEN
PLATEFORME MOBILE MODULAIRE DESTINÉE À ÊTRE UTILISÉE AVEC DES DISPOSITIFS COMMERCIAUX

(30) Priority: 29.06.2012 US 201261666288 P
(43) Date of publication of application: 13.11.2019
(62) Divisional of application: 13174417.9
(73) Proprietor: Airbus Operations GmbH, 21129 Hamburg (DE)
(72) Inventor: Reitmann, Jörg, 21129 Hamburg (DE)
(74) Representative: LKGLOBAL Lorenz & Kopf PartG mbB Patentanwälte

(56) References cited:
- FR-A1- 2 914 802
- US-A1- 2005 099 433
- US-A1- 2009 310 530
- US-A1- 2010 189 089

## Description

### TECHNICAL FIELD

The present teachings relate to an aircraft comprising a system for using an electronic device on the aircraft.

### BACKGROUND

Generally, mobile platforms are subjected to strict standards for their operation. In the example of an aircraft, the aircraft is required to meet airworthiness standards set forth by various aviation administrations. These standards make it difficult to update or upgrade systems in the aircraft in the event that new or better technology is developed. In this regard, aircraft are generally manufactured with a plurality of stand-alone systems, with each of these systems having dedicated hardware and software. Any changes to the hardware and software of these systems after airworthiness certification generally requires a re-certification of the system, thereby making updates and upgrades after the manufacture of the aircraft undesirable. Thus, the very short lifecycles of about 9 to about 18 months in the consumer information and communication technology industries do not necessarily match the lifecycles of the aircraft industry, and this may cause severe obsolescence problems. In many cases, the desired electronic components may become obsolete before the relevant equipment is re-certified and installed on the aircraft.

In addition, many mobile platforms are incompatible with commercial electronic devices. Generally, the commercial electronic devices have to be modified prior to use on the mobile platform, which can make the use of commercial electronic devices on the mobile platform cumbersome and can void manufacturers' warranties for the commercial electronic devices. US2009/310530 describes a portable communication system to allow a communication to be established between an aircraft and a ground station.

In addition, other objects, desirable features and characteristics will become apparent from the subsequent summary and detailed description, and the appended claims, taken in conjunction with the accompanying drawings and this background.

### SUMMARY

The invention is defined by the appended claims.

According to the invention, an aircraft comprising a system for using an electronic device on the aircraft is provided. The system comprising a first subsystem and a second subsystem, wherein the second subsystem is coupled to the first subsystem; the first subsystem is configured for avionic operation of the aircraft; wherein the second subsystem is adapted to enable modifications to the second subsystem without changing an infrastructure of the first subsystem; wherein the second subsystem comprises multiple modules which are retained in a cloud computing environment and downloaded to the aircraft from the cloud computing environment to enable customization of the aircraft without structural modifications to the first subsystem.

According to an embodiment, the second subsystem is implemented using shared resources, such as computers, data stores and communication devices, and are highly networked to enable later modifications and/or new functionality without changing the infrastructure formed by the first subsystem.

According to another embodiment, the use of multiple modules for the second subsystem allows customization of the aircraft without structural modifications to the first subsystem. According to another embodiment, the aircraft comprises an electronic device and a protective housing to encase the electronic device to be used on the aircraft without modification to the electronic device.

According to another embodiment, the electronic device includes a display, and the protective housing covers the display.

According to another embodiment, the protective housing protects the electronic device from at least one of temperature variations, pressure variations, operational loads and vibrations associated with the operation of the aircraft.

According to another embodiment, the protective housing shields the aircraft from interference caused by the operation of the electronic device.

According to another embodiment, the electronic device is selected from the group comprising: a cellular phone, a tablet computing device, a handheld digital assistant, a personal computer, a server and a data storage device.

According to an embodiment, the second subsystem is configured to be updated upon certification of the first subsystem without requiring re-certification of the aircraft.

The various embodiments will hereinafter be described in conjunction with the following drawing figures, wherein like numerals denote like elements, and wherein:
Fig. 1 is a schematic illustration of an exemplary modular aircraft; and
Fig. 2 is a schematic illustration of a protective housing for use with a commercial device within an aircraft.

### DESCRIPTION OF VARIOUS ASPECTS

The following detailed description is merely exemplary in nature and is not intended to limit the present disclosure or the application and uses of the present disclosure. Furthermore, there is no intention to be bound by any theory presented in the preceding background or the following detailed description. It should be understood that throughout the drawings, corresponding reference numerals indicate like or corresponding parts and features. Further, as used herein, the term module refers to any hardware, software, firmware, electronic control component, processing logic, and/or processor device, individually or in any combination, including without limitation: application specific integrated circuit (ASIC), an electronic circuit, a processor (shared, dedicated, or group) and memory that executes one or more software or firmware programs, a combinational logic circuit, and/or other suitable components that provide the described functionality. Therefore, it will be understood that the following discussions are not intended to limit the scope of the present teachings and claims herein.

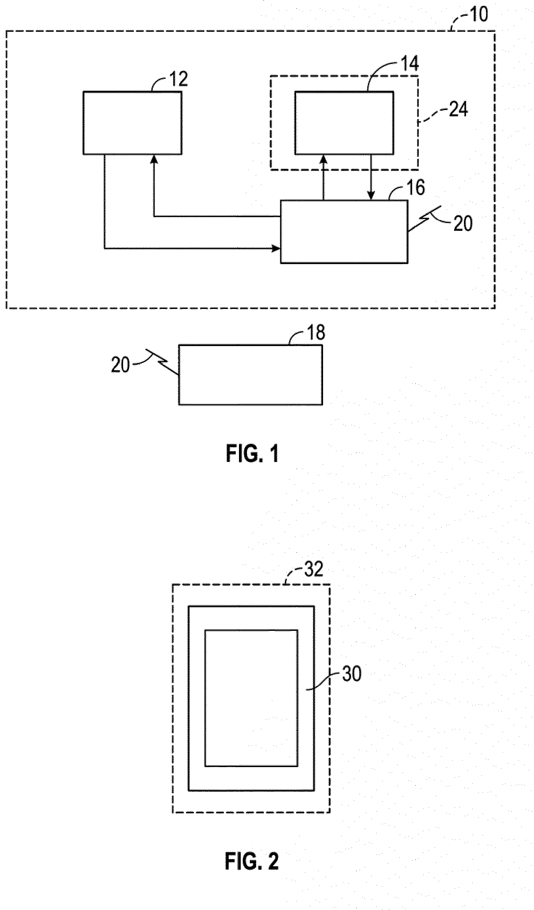

With reference to Fig. 1, an aircraft 10 is shown. In this example, the aircraft comprises a commercial aircraft 10, however, the aircraft can comprise an airborne military aircraft, unmanned air vehicle, or rotorcraft. The aircraft 10 includes one or more required systems 12 for the avionic operation of the aircraft 10. The aircraft 10 also includes various second subsystems 14, which are for consumer enjoyment on the aircraft 10. The required systems 12 and one or more of the second subsystems 14 are in communication with a communication system 16. The communication system 16 is in communication with a ground-based service system 18 to transfer/receive data over a communications link 20. In one example, one or more of the various second subsystems 14 comprises a modular system 24, which is couplable to a backbone, foundation or infrastructure formed by the required systems 12 of the aircraft 10.

In this regard, the required systems 12 comprise those systems required by airworthiness regulations. For example, the required systems 12 comprise systems required according to at least one of the Joint Aviation Requirements (JAR), the Federal Aviation Requirements (FAR), European Union Regulation on Air Operations (EU-OPS), and combinations thereof. Thus, the required systems 12 comprise the generally essential functions of an avionics system. According to the present teachings, the required systems 12 are formed to minimize complexity and to minimize interfaces and dependencies. For example, the required systems 12 include multi-functional and multiple advanced technology attachments (multi-ATA) network nodes, which are used to integrate various ones of the required systems 12. For example, a control system for the smoke detector is integrated with a control system for the emergency lights. It should be noted that various ones of the required systems 12 could be integrated, and the example contained herein is merely exemplary. The integration of various ones of the required systems 12 may reduce the weight of the aircraft 10 by reducing redundant components, which improves the fuel efficiency of the aircraft 10.

Generally, the required systems 12 form the backbone for the aircraft 10, which may be certified according to the various airworthiness standards. Once certified, this backbone interfaces with or is couplable with one or more systems of the second subsystems 14. By certifying the backbone or required systems 12 of the aircraft 10 separately from the second subsystems 14, the second subsystems 14 may be updated or upgraded without requiring re-certification of the aircraft 10. This reduces the cost and time associated with upgrading and updating the aircraft 10 to meet current technical expectations for the aircraft 10.

In addition, at least one of the required systems 12 may be implemented so as to be useable by commercially available consumer electronic devices. For example, a power supply system of the aircraft 10 is configured to meet current commercial power requirements such that a commercially available consumer electronic device is pluggable directly into the power supply system of the aircraft 10 without requiring an adaptor or modification to the commercially available consumer electronic device. Thus, the present disclosure creates a paradigm change, because in the past, the consumer electronic device was modified to meet the severe and mostly unique requirements for a particular aircraft. In this present disclosure, the aircraft 10 provides the electrical power used worldwide for consumer electronic devices, such as about 110 V/60 Hz with proper segregation and protection to or for the basic aircraft power supply network. This enables users of the aircraft 10 to use state of the art consumer electronics devices, such as smart phones, tablet computers, etc. without modification to the consumer electronic devices.

In one example, the second subsystems 14 include systems that are not required or are not generally essential to the airworthiness of the aircraft 10. For example, the second subsystems 14 include, but are not limited to, at least one of a connection flight information system, electronic flight book system, cabin surveillance system, cabin logbook system, cabin control system, crew communication system, cabin lighting system, cabin information display system, ground to satellite mobile communication system, pilot communication system, destination and route information service system, catering system, damage detection system, wireless internet system, in-flight entertainment system, including in-flight internet access system, in-flight shopping, in-flight gaming and in-flight video on demand service systems, an on board intranet service system, etc. The second subsystems 14 are implemented on commercially available components, which are coupled to the required systems 12. Generally, the second subsystems 14 are implemented using shared resources, such as computers, data stores and communication devices, and are highly networked to enable later modifications and/or new functionality without changing the infrastructure formed by the required systems 12.

In one example, one of the second subsystems 14 comprises a wireless network. The wireless network is configured according to consumer standards, so that commercially available consumer electronics, for example, the IPAD, commercially available from Apple, Inc. of Cupertino, California, may be used on the wireless network without substantial modifications. Further, the wireless or wired network employs standard Internet protocols. According to another of various examples, the on-board intranet service system can be implemented in the aircraft 10 using high bandwidth fiber optic cables. Additionally, one or more of the second subsystems 14 are implemented in a cloud computing environment.

In this regard, one or more of the various second subsystems 14 are modules, which are retained in the cloud computing environment. One or more of these modules are then downloaded to a desired aircraft 10 to enable customization of the aircraft 10. The use of modules for the second subsystems 14 allows the customization of the aircraft 10 without structural modifications to the required systems 12 after certification of the aircraft 10. This enables an aircraft manufacturer to meet the upcoming, very specific requirements of a wide variety of customers. Presently, the customer has to specify their required systems/features years prior delivery of the aircraft with the risk that their selection may be obsolete and/or their competitor has already a more advanced service flying at delivery of his first aircraft. Furthermore, these customers generally update and upgrade the aircraft over its whole lifecycle with the same speed and similar cost, dramatically reduced to the present praxis for smart phones or personal computers with new software applications and hardware devices with latest features. Even seasonal, route, or flight specific modifications are now feasible, because now these systems are communicated over the internet. This enables remote real-time updates/uploads including bug fixes, data security updates, content and download of performance and/or user/usage data for permanent system optimization.

The communication system 16 comprises a module that interfaces with the required systems 12, second subsystems 14 and the ground-based service system 18. In one example, the communication system 16 provides an operation center module, a cabin operations module and a portal module. Each of these modules of the communication system 16 communicates with the ground-based service system 18 over the communication link 20 by using satellite and terrestrial devices. The communication link 20 is established between a suitable transmitting/receiving device associated with the aircraft 10 and a suitable transmitting/receiving device associated with the ground-based service system 18.

The ground-based service system 18 comprises one or more systems that support the aircraft 10 during the operation of the aircraft 10. The ground-based service system 18 includes one or more systems that communicate with the communication system 16 to enable the proper operation of the required systems 12 and second subsystems 14. In addition, the ground-based service system 18 includes one or more systems that monitor the health of the aircraft 10. In this regard, one or more of the second subsystems 14 includes modules that monitor the usage and any technical issues associated with the second subsystems 14. This information is transmitted to the ground-based service system 18 in substantially real-time to enable monitoring, detection and correction of any technical issues associated with the second subsystems 14 in an expedient manner.

In another example, with reference to Fig. 2, a commercial device 30 is employed on the aircraft 10. The commercial device 30 comprises any suitable consumer electronic device, such as a cellular phone, tablet computing device, handheld digital assistant, personal computer, etc. It should be noted, however, that although the commercial device 30 is described herein as a personal electronic device, the commercial device 30 could comprise suitable commercially available computer hardware, such as servers, data storage devices, etc.

In one example, the aircraft 10 is provided with a power supply system and wireless or wired network configuration that enables the commercial device 30 to be employed on the aircraft 10 without requiring changes to the commercial device 30. Therefore, the basic aircraft 10 provides built in protection/hardening to ensure non- interference and/or non-penetration to its essential functions by means of strict segregation, separation, interface minimization, filtering, shielding, firewalls, digital authentication, encryption etc. If this protection against a particular risk is not sufficient, the commercial device 30 may need to be encased in a protective envelope or housing 32 to enable the operation of the commercial device 30 on the aircraft 10. For example, due to safety regulations, the commercial device 30 may need the protective housing 32 to cover the display of the commercial device 30 in case the display breaks or for head strike protection. As a further example, the commercial device 30 may require the use of the protective housing 32 to protect against temperature variations encountered during the flight of the aircraft 10, to provide fire resistance, and/or to ensure that during any detachment of the commercial device 30, the major parts of the commercial device 30 are contained. As a further example, the commercial device 30 may need the protective housing 32 to shield the aircraft 10 from electromagnetic interference caused by the commercial device 30. By cocooning the commercial device 30 in the protective housing 32, the commercial device 30 is useable in the aircraft 10 without modifications. This is desirable, as modifying the commercial device 30 to conform to the aircraft 10 in many instances can void any manufacturer's warranty associated with the commercial device 30 and last not least to procure these commercial devices 30 off the shelf.

In one example, the protective housing 32 is composed of steel or aramids for fire resistance, aluminum or glass/carbon fiber for mechanical strength or synthetic materials for drop resistance, waterproofness, anti-scratch and resistance to breakage. In one example, the structure of the protective housing 32 is a box, however, the protective housing 32 may be a protective glove, such as the type offered for smart phones as an accessory. Generally, the protective housing 32 is configured so as to not modify the commercial device 30 itself, but rather, to enable the commercial device 30 to be used off the shelf on the aircraft 10.

The use of commercial devices 30, such as a tablet computing device, provides real-time bidirectional access to databases such as booking, passenger list with preferences, catering, cargo, weather information as well as any informational materials, such as manuals and safety guides, which provide a daily interaction and learning experience for the users and the operators and service providers of the aircraft 10. This daily learning experience will optimize the system and enables a higher usability, availability and reliability, which provides a cost savings as well a higher quality of service. In addition, weight savings may also be realized.

Thus, the present disclosure provides an aircraft 10 that is updated, upgraded and customized without requiring modification or re-certification of the required systems 12 of the aircraft 10. The ability to update and upgrade the second subsystems 14 of the aircraft 10 without re-certification enables the aircraft 10 to keep up with evolving technologies. In addition, the use of integrated systems reduces the weight of the aircraft 10, thereby reducing operational costs associated with the aircraft 10. Further, by providing the aircraft 10 with the ability to interface with commercial devices 30, the commercial devices 30 do not have to be modified to be used on the aircraft 10, which maintains the manufacturer's warranty for the commercial devices 30.

## Claims

1. An aircraft (10) comprising a system for using an electronic device on the aircraft (10), the system comprising:
a first subsystem (12) and a second subsystem (14), wherein the second subsystem (14) is coupled to the first subsystem (12);
wherein the first subsystem (12) is configured for avionic operation of the aircraft (10);
**characterized in that** the second subsystem (14) is adapted to enable modifications to the second subsystem without changing an infrastructure of the first subsystem (12)
wherein the second subsystem (14) comprises multiple modules which are retained in a cloud computing environment and downloaded to the aircraft from the cloud computing environment to enable customization of the aircraft without structural modifications to the first subsystem (12).

2. The aircraft (10) of claim 1, wherein the second subsystem (14) is implemented using shared resources, such as computers, data stores and communication devices, and are highly networked to enable later modifications and/or new functionality without changing the infrastructure formed by the first subsystem (12).

3. The aircraft (10) of claim 1 or 2,
the use of multiple modules for the second subsystem (14) allows customization of the aircraft without structural modifications to the first subsystem (12).

4. The aircraft (10) of any one of the preceding claims,
wherein the aircraft further comprises an electronic device and a protective housing to encase the electronic device to enable the electronic device to be used on the aircraft without modification to the electronic device.

5. The aircraft (10) of claim 4, wherein the electronic device includes a display, and the protective housing covers the display.

6. The aircraft (10) of claim 4 or 5, wherein the protective housing is configured to protect the electronic device from at least one of temperature variations, pressure variations, operational loads and vibrations associated with the operation of the aircraft.

7. The aircraft (10) of any one of the claims 4 to 6, wherein the protective housing is configured to shield the aircraft from interference caused by the operation of the electronic device.

8. The aircraft (10) of any one of the claims 4 to 7, wherein the electronic device is selected from the group comprising: a cellular phone, a tablet computing device, a handheld digital assistant, a personal computer, a server and a data storage device.

9. The aircraft (10) of any one of the preceding claims,
wherein the second subsystem (14) is configured to be updated upon certification of the first subsystem (12) without requiring re-certification of the aircraft (10).

## Patentansprüche

1. Flugzeug (10), umfassend ein System zum Verwenden einer elektronischen Vorrichtung auf dem Flugzeug (10), wobei das System Folgendes umfasst:
ein erstes Untersystem (12) und ein zweites Untersystem (14), wobei das zweite Untersystem (14) mit dem ersten Untersystem (12) gekoppelt ist;
wobei das erste Untersystem (12) ausgelegt ist für avionischen Betrieb des Flugzeugs (10);
**dadurch gekennzeichnet, dass** das zweite Untersystem (14) dazu angepasst ist, Modifikationen am zweiten Untersystem zu ermöglichen, ohne eine Infrastruktur des ersten Untersystems (12) zu ändern;
wobei das zweite Untersystem (14) mehrere Module umfasst, die in einer Cloud-Datenverarbeitungsumgebung gehalten und aus der Cloud-Datenverarbeitungsumgebung auf das Flugzeug heruntergeladen werden, um Anpassung des Flugzeugs ohne strukturelle Modifikationen am ersten Untersystem (12) zu ermöglichen.

2. Flugzeug (10) nach Anspruch 1,
wobei das zweite Untersystem (14) unter Verwendung gemeinsam genutzter Ressourcen implementiert wird, wie etwa Computern, Datenspeichern und Kommunikationsvorrichtungen, die hochgradig vernetzt sind, um spätere Modifikationen und/oder neue Funktionalitäten zu ermöglichen, ohne die durch das erste Untersystem (12) gebildete Infrastruktur zu ändern.

3. Flugzeug (10) nach Anspruch 1 oder 2,
wobei die Verwendung mehrerer Module für das zweite Untersystem (14) Anpassungen des Flugzeugs ohne strukturelle Modifikationen am ersten Untersystem (12) ermöglicht.

4. Flugzeug (10) nach einem der vorhergehenden Ansprüche,
wobei das Flugzeug ferner eine elektronische Vorrichtung und ein Schutzgehäuse zum Einhausen der elektronischen Vorrichtung umfasst, um der elektronischen Vorrichtung zu ermöglichen, ohne Modifikation an der elektronischen Vorrichtung auf dem Flugzeug verwendet zu werden.

5. Flugzeug (10) nach Anspruch 4,
wobei die elektronische Vorrichtung eine Anzeige umfasst und das Schutzgehäuse die Anzeige bedeckt.

6. Flugzeug (10) nach Anspruch 4 oder 5,
wobei das Schutzgehäuse dazu ausgelegt ist, die elektronische Vorrichtung vor zumindest einem aus Temperaturschwankungen, Druckschwankungen, Betriebslasten und Vibrationen im Zusammenhang mit dem Betrieb des Flugzeugs zu schützen.

7. Flugzeug (10) nach einem der Ansprüche 4 bis 6, wobei das Schutzgehäuse dazu ausgelegt ist, das Flugzeug vor Interferenz zu schützen, die durch den Betrieb der elektronischen Vorrichtung verursacht wird.

8. Flugzeug (10) nach einem der Ansprüche 4 bis 7, wobei die elektronische Vorrichtung aus der Gruppe ausgewählt wird, die besteht aus: einem Mobiltelefon, einer Tablet-Datenverarbeitungsvorrichtung, einem handgehaltenen digitalen Assistenten, einem Personalcomputer, einem Server und einer Datenspeicherungsvorrichtung.

9. Flugzeug (10) nach einem der vorhergehenden Ansprüche,
wobei das zweite Untersystem (14) dazu ausgelegt ist, bei Zertifizierung des ersten Untersystems (12) aktualisiert zu werden, ohne eine erneute Zertifizierung des Flugzeugs (10) zu erfordern.

## Revendications

1. Aéronef (10), comprenant un système pour l'utilisation d'un dispositif électronique à bord de l'aéronef (10), le système comprenant :
un premier sous-système (12) et un deuxième sous-système (14), le deuxième sous-système (14) étant couplé au premier sous-système (12) ;
le premier sous-système (12) étant configuré pour le fonctionnement avionique de l'aéronef (10) ;
**caractérisé en ce que** le deuxième sous-système (14) est adapté à permettre d'apporter des modifications au deuxième sous-système sans changer une infrastructure du premier sous-système (12) ;
le deuxième sous-système (14) comprenant de multiples modules qui sont conservés dans un environnement informatique dans le cloud et téléchargés vers l'aéronef à partir de l'environnement informatique dans le cloud pour permettre la personnalisation de l'aéronef sans apporter de modifications structurales au premier sous-système (12).

2. Aéronef (10) selon la revendication 1, dans lequel le deuxième sous-système (14) est mis en œuvre au moyen de ressources partagées, telles que des ordinateurs, des magasins de données et des dispositifs de communication, et est hautement réseauté pour permettre des modifications ultérieures et/ou une nouvelle fonctionnalité sans changement de l'infrastructure formée par le premier sous-système (12).

3. Aéronef (10) selon la revendication 1 ou 2,
dans lequel l'utilisation de multiples modules pour le deuxième sous-système (14) permet la personnalisation de l'aéronef sans apporter de modifications structurales au premier sous-système (12).

4. Aéronef (10) selon l'une quelconque des revendications précédentes,
l'aéronef comprenant en outre un dispositif électronique et une coque de protection pour renfermer le dispositif électronique pour permettre l'utilisation du dispositif électronique à bord de l'aéronef sans apporter de modification au dispositif électronique.

5. Aéronef (10) selon la revendication 4, dans lequel le dispositif électronique comporte un affichage, et la coque de protection recouvre l'affichage.

6. Aéronef (10) selon la revendication 4 ou 5, dans lequel la coque de protection est configurée pour protéger le dispositif électronique de variations de température et/ou de variations de pression et/ou de charges opérationnelles et/ou de vibrations associées au fonctionnement de l'aéronef.

7. Aéronef (10) selon l'une quelconque des revendications 4 à 6, dans lequel la coque de protection est configurée pour protéger l'aéronef des interférences dues au fonctionnement du dispositif électronique.

8. Aéronef (10) selon l'une quelconque des revendications 4 à 7, dans lequel le dispositif électronique est sélectionné dans le groupe comprenant : un téléphone cellulaire, une tablette informatique, un assistant numérique de poche, un ordinateur personnel, un serveur et un dispositif de stockage de données.

9. Aéronef (10) selon l'une quelconque des revendications précédentes,
dans lequel le deuxième sous-système (14) est configuré pour être mis à jour lors de la certification du premier sous-système (12) sans nécessiter la recertification de l'aéronef (10).
